# EUROPÄISCHE PATENTSCHRIFT

(11) **EP 3 381 054 B1**
(45) Veröffentlichungstag und Bekanntmachung des Hinweises auf die Patenterteilung: **11.12.2019**
(21) Anmeldenummer: 16782222.0
(22) Anmeldetag: 17.10.2016
(51) Int. Cl.: H01L 25/07

(54) **LEISTUNGSMODUL FÜR EINEN ELEKTROMOTOR**
POWER MODULE FOR AN ELECTRIC MOTOR
MODULE DE PUISSANCE DESTINÉ À UN MOTEUR ÉLECTRIQUE

(30) Priorität: 27.11.2015 DE 102015223602
(43) Veröffentlichungstag der Anmeldung: 03.10.2018
(73) Patentinhaber: Robert Bosch GmbH, 70442 Stuttgart (DE)
(72) Erfinder: ILIC, Erich, 72805 Lichtenstein (DE); HIRSCHLE, Johannes, 72537 Mehrstetten (DE); VON EMDEN, Walter, 72800 Enigen Unter Achalm (DE); BETZ, Volker, 72116 Moessingen (DE)
(86) Internationale Anmeldenummer: PCT/EP2016/074869
(87) Internationale Veröffentlichungsnummer: WO 2017/089028

(56) Entgegenhaltungen:
- EP-A1- 2 546 874
- EP-A2- 2 477 222

## Beschreibung

### Stand der Technik

Die Erfindung betrifft ein Leistungsmodul für einen Elektromotor. Das Leistungsmodul weist wenigstens eine Halbleiterschalter-Halbbrücke auf.

Ein solches Modul ist zum Beispiel in EP 2 456 874 or EP 2 477 222 offenbart.

### Offenbarung der Erfindung

Erfindungsgemäß weist die Halbleiterschalter-Halbbrücke einen High-Side-Halbleiterschalter und einen Low-Side-Halbleiterschalter auf, wobei die Halbleiterschalter der Halbbrücke jeweils durch einen insbesondere flach ausgebildeten Oberflächenbereich des Halbleiterschalters gebildete Schaltstreckenanschlüsse aufweisen. Die Schaltstreckenanschlüsse, insbesondere ein Flächen-Normalenvektor des Schaltstreckenanschlusses, weisen jeweils in dieselbe Richtung. Der High-Side-Halbleiterschalter und der Low-Side-Halbleiterschalter schließen wenigstens eine elektrisch leitfähige Schicht zwischeneinander ein, welche einen Schaltstreckenanschluss des Low-Side-Halbleiterschalters und einen Schaltstreckenanschluss des High-Side-Halbleiterschalters der Halbbrücke miteinander elektrisch verbindet. Bevorzugt ist durch wenigstens eine elektrisch leitfähige Schicht ein Ausgangsanschluss der Halbbrücke gebildet. Durch einen solchen Aufbau kann vorteilhaft ein kompaktes Leistungsmodul bereitgestellt sein. Das Leistungsmodul kann so in einem Elektromotor platzsparend angeordnet sein.

In einer bevorzugten Ausführungsform des Leistungsmoduls liegen die Schaltstreckenanschlüsse der Halbleiterschalter einer Halbbrücke einander gegenüber. Bevorzugt sind die Schaltstreckenanschlüsse eines Halbleiterschalters zueinander koplanar angeordnet. Die Schaltstreckenanschlüsse, welche mittels der elektrisch leitfähigen Schicht miteinander verbunden sind, können so die elektrisch leitfähige Schicht - insbesondere nach Art eines Sandwiches - zwischeneinander einschließen. So kann das Leistungsmodul vorteilhaft platzsparend aufgebaut sein.

In einer bevorzugten Ausführungsform ist das Leistungsmodul zur mehrphasigen Schaltung, insbesondere Schaltung von Motorströmen, ausgebildet und weist für jede Phase wenigstens eine oder nur eine Halbleiterschalter-Halbbrücke auf. Das Leistungsmodul kann so beispielsweise zur Ansteuerung eines dreiphasigen Motors drei Halbleiterschalter-Halbbrücken aufweisen. Jede Halbleiterschalter-Halbbrücke kann beispielsweise eine Mehrzahl oder eine Vielzahl von Einzelhalbleiterschalter-Halbbrücken aufweisen, welche zueinander parallel geschaltet sind, insbesondere als Strang angeordnet sind.

Die Halbleiterschalter-Halbbrücke weist bevorzugt für jeden Schaltstreckenanschluss wenigstens zwei, drei oder vier, oder mehr als vier Oberflächenbereiche auf, welche elektrisch leitfähig ausgebildet sind und mit dem Schaltstreckenanschluss verbunden sind. Die Oberflächenbereiche können so jeweils ein Kontakt-Pad bilden.

In einer bevorzugten Ausführungsform des Leistungsmoduls weist die elektrisch leitfähige Schicht eine Phasenstromschiene auf, an die in einer flachen Erstreckung der Schicht wenigstens ein von der Phasenstromschiene quer oder mit einer Querkomponente abweisender Kontaktfinger angeformt ist. Der Kontaktfinger verbindet bevorzugt die mit dem Ausgangsanschluss verbundenen Schaltstreckenanschlüsse der Halbleiterschalter miteinander. Die Kontaktschiene kann so vorteilhaft eine Sammelschiene bilden, welche die von den Kontaktfingern abgeführten Ströme bündelt, oder welche einen Strom auf die Kontaktfinger verteilt, wobei der verteilte Strom mittels der Kontaktfinger zu den Schaltstreckenanschlüssen geführt werden kann.

Weiter vorteilhaft kann die Stromschiene aus einem Leistungsmodul, welches beispielsweise durch ein Mold-Modul gebildet ist, aus einem Moldkörper des Mold-Moduls herausragen, und so von außen elektrisch kontaktiert werden.

In einer bevorzugten Ausführungsform sind die Halbleiterschalter jeweils durch einen Feldeffekttransistor gebildet, wobei der mit dem Ausgangsanschluss der Halbbrücke verbundene Schaltstreckenanschluss des High-Side-Halbleiterschalters ein Source-Anschluss ist, und der mit dem Ausgangsanschluss der Halbbrücke verbundene Schaltstreckenanschluss des Low-Side-Halbleiterschalters ein Drain-Anschluss ist. So kann eine Halbleiterschalter-Halbbrücke, gebildet aus zwei MOS-Feldeffekttransistoren (MOS = Metal-Oxide-Semiconductor), oder MIS-Feldeffekttransistoren (MIS = Metal-Insulator-Semicobductor), vorteilhaft kompakt und platzsparend aufgebaut sein. Weiter vorteilhaft kann durch den kompakten Aufbau das Leistungsmodul eine geringe Eigeninduktivität aufweisen.

In einer bevorzugten Ausführungsform sind die Halbleiterschalter jeweils durch einen IGBT (IGBT = Insulated-Gate-Bipolar-Transistor) gebildet, wobei der mit dem Ausgangsanschluss der Halbbrücke verbundene Schaltstreckenanschluss des High-Side-Halbleiterschalters ein Emitter-Anschluss ist und der mit dem Ausgangsanschluss der Halbbrücke verbundene Schaltstreckenanschluss des Low-Side-Halbleiterschalters ein Kollektor-Anschluss ist. Die Halbbrücke kann so - bestehend aus IGBT-Transistoren - vorteilhaft platzsparend aufgebaut sein.

In einer bevorzugten Ausführungsform umfasst der Kontaktfinger zwei zueinander parallel angeordnete elektrisch leitfähige Schichten, welche durch eine elektrisch isolierende Isolierschicht voneinander getrennt sind. Die Schichten des Kontaktfingers kontaktieren bevorzugt einander gegenüberliegende Anschlüsse zueinander verschiedener Halbleiterschalter. So kann vorteilhaft aus dem Zwischenraum, welcher sich zwischen dem Low-Side-Halbleiterschalter und dem High-Side-Halbleiterschalter erstreckt, platzsparend und niederinduktiv die Halbbrücke, insbesondere die Halbleiterschalter der Halbbrücke, mit Spannung versorgt werden.

Bevorzugt ist die elektrisch isolierende Isolierschicht durch ein Dielektrikum gebildet. Das Dielektrikum ist beispielsweise eine Polyimidschicht oder eine Polyamidschicht. Auf diese Weise kann vorteilhaft ein - der Fläche der zwei zueinander parallel angeordneten elektrisch leitfähigen Schichten entsprechender - Zwischenkreiskondensator gebildet sein, welcher so in dem Leistungsmodul integriert ist.

In einer bevorzugten Ausführungsform greifen die Kontaktfinger der Phasenstromschiene und der Stromschiene jeweils ineinander. Auf diese Weise kann die Stromzufuhr und die Stromabfuhr aus dem Leistungsmodul besonders kompakt ausgebildet sein.

Die Erfindung wird nun im Folgenden anhand von Figuren und weiteren Ausführungsbeispielen beschrieben. Weitere vorteilhafte Ausführungsvarianten ergeben sich aus den in den abhängigen Ansprüchen und in den Figuren beschriebenen Merkmalen.
Figur 1 zeigt - schematisch - ein Ausführungsbeispiel für eine Halbleiteranordnung, die eine Halbleiterschalter-Halbbrücke bildet, bei der zwei Halbleiterschalter elektrische Kontakte zur Stromzufuhr und Stromabfuhr zwischeneinander einschließen;
Figur 2 zeigt - schematisch in einer Explosionsdarstellung - eine Halbleiteranordnung in zum Ausbilden von drei Halbleiterschalter-Halbbrücken, gebildet aus FET-Transistoren, wobei elektrische Kontakte zur Stromzufuhr und Stromabfuhr zwischen den Low-Side- und den High-Side-Transistoren eingeschlossen sind;
Figur 3 zeigt einen Fertigungsschritt zum Ausbilden eines Leistungsmoduls umfassend die in Figur 2 dargestellten Komponenten, wobei die High-Side-Transistoren mit elektrischen Anschlüssen, insbesondere einer Stromschiene und Ausgangsanschlüssen verlötet werden;
Figur 4 zeigt einen Fertigungsschritt zum Ausbilden eines Leistungsmoduls umfassend die in Figur 3 dargestellten Komponenten, wobei Low-Side-Halbleiterschalter mit elektrischen Anschlüssen, insbesondere der Stromschiene und den Ausgangsanschlüssen verlötet werden;
Figur 5 zeigt einen weiteren Fertigungsschritt zum Ausbilden eines Leistungsmoduls umfassend die in Figur 4 dargestellten Komponenten, wobei die Komponenten in Moldmasse eingebettet werden;
Figur 6 zeigt eine Variante der in Figur 4 dargestellten Halbleiteranordnung, bei der die Halbbrücken ausgangsseitig mit einem Phasentrennschalter verbunden werden;
Figur 7 zeigt einen Fertigungsschritt zum Erzeugen eines Leistungsmoduls mit Phasentrennschaltern, bei dem Low-Side-Halbleiterschalter auf elektrische Anschlüsse aufgelötet werden;
Figur 8 zeigt einen Fertigungsschritt zum Erzeugen eines Leistungsmoduls mit Phasentrennschaltern, bei dem die in Figur 7 gezeigten Komponenten in Moldmasse eingebettet werden.

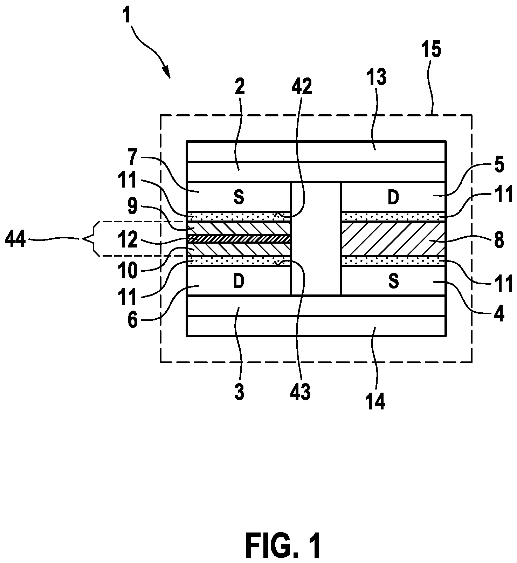

Figur 1 zeigt ein Ausführungsbeispiel für eine Halbleiteranordnung 1. Die Halbleiteranordnung 1 bildet in diesem Ausführungsbeispiel ein Leistungsmodul, das eine Halbleiterschalter-Halbbrücke umfasst. Die Halbleiterschalter-Halbbrücke umfasst in diesem Ausführungsbeispiel einen Low-Side-Halbleiterschalter 2 und einen High-Side-Halbleiterschalter 3. Der Low-Side-Halbleiterschalter 2, welcher in diesem Ausführungsbeispiel durch einen Feldeffekttransistor gebildet ist, weist als Schaltstreckenanschluss einen Source-Anschluss 7 und einen Drain-Anschluss 5 als weiteren Schaltstreckenanschluss auf. Der High-Side-Halbleiterschalter 3 weist als Schaltstreckenanschluss einen Drain-Anschluss 6 und als weiteren Schaltstreckenanschluss einen Source-Anschluss 4 auf. Der Source-Anschluss 4 des High-Side-Halbleiterschalters 3 ist mit dem Drain-Anschluss 5 des Low-Side-Halbleiterschalters elektrisch verbunden. Die Halbleiterschalter 2 und 3 sind jeweils flach ausgebildet. Der Source-Anschluss 7 weist einen Oberflächenbereich 42 auf, welcher zu einem Oberflächenbereich 43 des Drain-Anschlusses 6 des High-Side-Halbleiterschalters 3 gegenüberliegend angeordnet ist. Der Source-Anschluss 7 und der Drain-Anschluss 5 des Low-Side-Halbleiterschalters 2 erstrecken sich jeweils in einer gemeinsamen Ebene.

Der Drain-Anschluss 5 des Low-Side-Halbleiterschalters 2 und der Source-Anschluss 4 des High-Side-Halbleiterschalters 3 schließen einen Ausgangsanschluss 8 zwischeneinander ein und sind jeweils mittels eines elektrischen Verbindungsmittels 11 mit dem Ausgangsanschluss 8 stoffschlüssig oder materialschlüssig elektrisch verbunden. Das Verbindungsmittel 11 ist beispielsweise ein Lotmittel, eine Sinterlotverbindung oder ein elektrisch leitfähiger Klebstoff. Der Ausgangsanschluss 8 ist in diesem Ausführungsbeispiel durch ein sich flach erstreckendes Blechstück oder Blechstreifen, auch Stanzgitter oder Leadframe genannt, gebildet. Der Ausgangsanschluss 8 ist beispielsweise durch Kupfer- oder Silberblech gebildet. Der Ausgangsanschluss 8 kann beispielsweise durch einen Kontaktfinger gebildet sein.

Der Source-Anschluss 7 ist in diesem Ausführungsbeispiel mittels eines Verbindungsmittels 11, insbesondere Lotmittel, elektrisch leitfähiger Klebstoff oder Sintermetall mit einer elektrisch leitfähigen Schicht 9 verbunden. Die elektrisch leitfähige Schicht 9 kann beispielsweise einen Ausgangsanschluss zur Stromversorgung der Halbleiterschalter-Halbbrücke bilden. Der Drain-Anschluss 6 ist mittels eines Verbindungsmittels 11, insbesondere Lotmittels oder elektrisch leitfähiger Klebstoff oder Sintermetall mit einer elektrisch leitfähigen Schicht 10 verbunden. Die elektrisch leitfähige Schicht 10 bildet in diesem Ausführungsbeispiel einen weiteren Anschluss zur Stromversorgung der Halbleiterschalter-Halbbrücke. Die elektrisch leitfähigen Schichten 9 und 10 sind in diesem Ausführungsbeispiel parallel und zueinander beabstandet angeordnet und schließen eine elektrisch isolierende Schicht 12 zwischeneinander ein. Die elektrisch leitfähigen Schichten 9 und 10 sind so elektrisch voneinander isoliert.

Der Source-Anschluss 7 und der Drain-Anschluss 6 schließen die elektrisch leitfähigen Schichten 9 und 10 und die - nach Art eines Sandwiches zwischen den elektrisch leitfähigen Schichten 9 und 10 eingeschlossene - elektrisch isolierende Schicht 12 zwischeneinander ein. Der Oberflächenbereich 42 des Source-Anschlusses 7 wird so durch die elektrisch leitfähige Schicht 9 elektrisch kontaktiert und der Oberflächenbereich 43 des Drain-Anschlusses 6 wird durch die elektrisch leitfähige Schicht 10 elektrisch kontaktiert. Die elektrisch leitfähigen Schichten 9 und 10 sind beispielsweise nach außen geführt, sodass der Halbleiterschalter so von außen elektrisch kontaktiert werden kann.

Die so gebildete Halbleiterschalter-Halbbrücke, welche kompakt aufgebaut ist, kann in einen Moldkörper 15 eingebettet sein. Der Ausgangsanschluss 8, welcher beispielsweise als elektrisch leitfähige Schicht ausgebildet ist, ragt in diesem Ausführungsbeispiel aus dem Moldkörper 15 heraus. Die elektrisch leitfähige Schicht 9, die elektrisch leitfähige Schicht 10 und die dazwischen eingeschlossene Isolierschicht 12 können zusammen eine Stromschiene 44 oder einen Bestandteil einer Stromschiene bilden und ragen gemeinsam aus dem Moldkörper 15 heraus. Die Halbleiterschalter-Halbbrücke kann so über die Stromschiene 44 mit Strom versorgt werden, wobei der Strom - geschaltet durch den Low-Side-Halbleiterschalter 2 und den High-Side-Halbleiterschalter 3 - über den Ausgangsanschluss 8 ab fließen kann.

Der Low-Side-Halbleiterschalter 2 weist eine nach außen weisende Isolierschicht 13 auf, über die im Halbleiterschalter 2 erzeugte Verlustwärme abgeführt werden kann. Der High-Side-Halbleiterschalter 3 weist eine nach außen weisende Isolierschicht 14 auf, über die im Halbleiterschalter 2 erzeugte Verlustwärme abgeführt werden kann. Die Halbbrücke umfassend die Halbleiterschalter 2 und 3 kann so vorteilhaft über zwei voneinander abweisende Seiten entwärmt werden. Die Isolierschichten 13 und 14 können jeweils durch eine Keramikschicht, DBC-Schicht (DBC = Direct-Bonded-Copper), bei der eine Kupferschicht zum stoffschlüssigen Verbinden, insbesondere Verlöten oder Sintern mit einer Wärmesenke nach außen weist, gebildet sein. An die Isolierschichten 13 und 14, welche beispielsweise durch eine Polyimidschicht gebildet sind, kann eine Wärmesenke, beispielsweise ein Kühlkörper, mittels eines Wärmeleitklebstoffs angekoppelt sein.

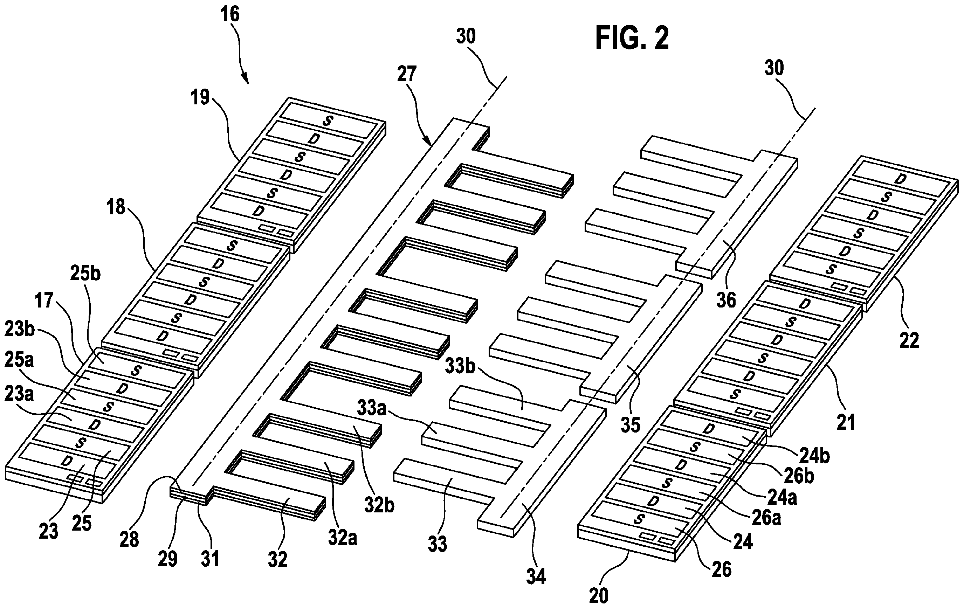

Figur 2 zeigt - schematisch - Bestandteile einer Halbleiteranordnung 16, in einer Explosionsdarstellung. Die Halbleiteranordnung 16 bildet in diesem Ausführungsbeispiel ein Leistungsmodul, welches drei Halbleiterschalter-Halbbrücken zur Ansteuerung eines dreiphasigen Elektromotors oder einer dreiphasigen elektrischen Maschine aufweist. Die Halbleiteranordnung 16 umfasst in diesem Ausführungsbeispiel drei High-Side-Halbleiterschalter, nämlich einen High-Side-Feldeffekttransistor 17, einen High-Side-Feldeffekttransistor 18 und einen High-Side-Feldeffekttransistor 19. Die Feldeffekttransistoren 17, 18 und 19 sind jeweils flach ausgebildet, wobei die Schaltstreckenanschlüsse, insbesondere ein Drain-Anschluss 23, und ein Source-Anschluss 25, jeweils - mit ihrer flachen Erstreckung - in dieselbe Richtung weisen.

Der Drain-Anschluss 23 des Halbleiterschalters 17 ist noch durch zwei weitere Anschlussteile 23a und 23b gebildet. Der Source-Anschluss des Halbleiterschalters 17 umfasst neben dem Source-Anschluss 25 noch zwei weitere Anschlussteile 25a und 25b, welche jeweils durch einen Oberflächenbereich des Halbleiterschalters 17 gebildet sind.

Die Oberflächenbereiche, welche den Source- und den Drain-Anschluss des Halbleiterschalters 17 bilden, wechseln entlang einer Längsachse 30 einander alternierend ab. So ist entlang der Längsachse 30 der Oberflächenbereich, welcher den Source-Anschluss 25 bildet, zu dem Oberflächenbereich, welcher den Drain-Anschluss 23 bildet, benachbart angeordnet. Auf den Oberflächenbereich, welcher den Source-Anschluss 25 bildet, folgt der Oberflächenbereich, welcher den Drain-Anschlussteil 23a bildet. Auf den Drain-Anschlussteil 23a folgt entlang der Längsachse der Source-Anschlussteil 25a und auf den Source-Anschlussteil 25a der Drain-Anschlussteil 23b. Auf den Drain-Anschlussteil 23b folgt der Source-Anschlussteil 25b. So schließen zwei entlang der Längsachse 30 angeordnete Source-Anschlussteile einen Drain-Anschlussteil zwischeneinander ein und entlang der Längsachse 30 angeordnete Drain-Anschlussteile schließen einen Source-Anschlussteil zwischeneinander ein.

Die Halbleiteranordnung 16 umfasst auch eine Stromschiene 27, welche in diesem Ausführungsbeispiel zwei zueinander parallel angeordnete und mittels einer Isolierschicht 29 voneinander elektrisch getrennte elektrisch leitfähige Schichten 28 und 31 umfasst. Die Stromschiene 27 erstreckt sich entlang der Längsachse 30. An die Stromschiene 27 sind entlang der Längsachse 30 zueinander beabstandet Kontaktfinger wie der Kontaktfinger 32 angeformt, wobei die Kontaktfinger jeweils - wie die Stromschiene 27 - die elektrisch leitfähigen Schichten 28 und 31 und die dazwischen angeordnete Isolierschicht 29 umfassen. Die Stromschiene 27 und die an die Stromschiene 27 angeformten Kontaktfinger umfassen somit zwei zueinander parallel angeordnete und mittels der Isolierschicht 29 voneinander elektrisch isolierte Kontaktebenen.

Die elektrisch leitfähige Schicht 31 des Kontaktfingers 32 ist ausgebildet, mit dem Drain-Anschluss 23 verlötet zu werden. An die Stromschiene 27 sind in diesem Ausführungsbeispiel noch zwei weitere, entlang der Längsachse 30 zueinander beabstandete Kontaktfinger 32a und 32b angeformt. Die elektrisch leitfähige Schicht 31 des Kontaktfingers 32a ist ausgebildet, mit dem Drain-Anschluss 23a elektrisch verbunden, insbesondere verlötet, beispielsweise reflow-verlötet, zu werden. Die elektrisch leitfähige Schicht 31 des Kontaktfingers 32b ist ausgebildet, mit dem Drain-Anschluss 23b verlötet zu werden. Die Stromschiene 27, insbesondere die elektrisch leitfähige Schicht 31 der Stromschiene 27, kann somit mittels der Kontaktfinger 32, 32a und 32b mit dem Drain-Anschluss, insbesondere den Drain-Anschlussteilen 23, 23a und 23b des Halbleiterschalters 17 elektrisch verbunden werden. Der Halbleiterschalter 17 kann so mittels der Stromschiene 27 mit einer elektrischen Spannungsquelle, insbesondere einem Pluspol der Spannungsquelle, elektrisch verbunden werden.

Die Halbleiteranordnung 16 umfasst auch einen Low-Side-Halbleiterschalter 20, welcher ausgebildet ist, mit dem High-Side-Halbleiterschalter 17 gemeinsam eine Halbleiterschalter-Halbbrücke zu bilden. Die Halbleiteranordnung 16 umfasst auch einen Halbleiterschalter 21, welcher ausgebildet ist, gemeinsam mit dem High-Side-Halbleiterschalter 18 eine Halbleiterschalter-Halbbrücke zu bilden und einen weiteren Low-Side-Halbleiterschalter 22, welcher ausgebildet ist, gemeinsam mit dem High-Side-Halbleiterschalter 19 eine Halbleiterschalter-Halbbrücke auszubilden.

Die Halbleiteranordnung 16 umfasst auch einen Ausgangsanschluss 34, welcher in diesem Ausführungsbeispiel als - beispielsweise gestanztes oder lasergeschnittenes - Blechstück, auch Stanzgitter oder Leadframe genannt, ausgebildet ist. Der Ausgangsanschluss 34 umfasst eine sich entlang der Längsachse 30 erstreckende Stromschiene und entlang der Längsachse 30 zueinander beabstandet an die Stromschiene angeformte Kontaktfinger 33, 33a und 33b.

Der Kontaktfinger 33 ist ausgebildet, mit einer flachen Seite mit dem Source-Anschluss 25 des High-Side-Halbleiterschalters 17 verlötet zu werden und mit einer dazu gegenüberliegenden Seite mit einem Drain-Anschluss 24 des Low-Side-Halbleiterschalters 20 verlötet zu werden. Ein zu dem Drain-Anschluss 24 entlang der Längsachse 30 benachbart angeordneter Source-Anschluss 26 des Low-Side-Halbleiterschalters 20 ist ausgebildet, mit der elektrisch leitfähigen Schicht 28 des Kontaktfingers 32 verlötet zu werden, sodass der Source-Anschluss 26 über die Stromschiene 27, insbesondere die elektrisch leitfähige Schicht 28 der Stromschiene 27, mit einem Pol einer Spannungsquelle, insbesondere Minuspol der Spannungsquelle, verbunden werden kann.

Der Kontaktfinger 33a ist ausgebildet, mit dem Source-Anschluss 25a verlötet zu werden und der Kontaktfinger 33b ist ausgebildet, mit dem Source-Anschluss 25b verbunden zu werden.

Der Kontaktfinger 33 des Ausgangsanschlusses 34 verbindet so den Source-Anschluss 25 des High-Side-Halbleiterschalters 17 mit dem Drain-Anschluss 24 des Low-Side-Halbleiterschalters 20 und einen Teilanschluss 24a des Drain-Anschlusses 24 mit dem Teilanschluss 25a des Source-Anschlusses 25. Der Kontaktfinger 33b verbindet den Teilanschluss 24b des Drain-Anschlusses des Low-Side-Halbleiterschalters 20 mit dem Teilanschluss 25b des Source-Anschlusses 25 des High-Side-Halbleiterschalters 17. Die Kontaktfinger 33, 33a und 33b des Ausgangsanschlusses 34 sind somit - nach Art eines Sandwiches - zwischen den sich jeweils flach erstreckenden Halbleiterschaltern, nämlich dem High-Side-Halbleiterschalter 17 und dem Low-Side-Halbleiterschalter 20, eingeschlossen.

An die Stromschiene 27 sind noch weitere Kontaktfinger zum elektrischen Kontaktieren des High-Side-Halbleiterschalters 18 und noch weitere drei Kontaktfinger zum elektrischen Kontaktieren des High-Side-Halbleiterschalters 19 angeformt.

Die Halbleiteranordnung 16 umfasst auch einen Ausgangsanschluss 35 für die Halbleiterschalter-Halbbrücke, umfassend den High-Side-Halbleiterschalter 18 und den Low-Side-Halbleiterschalter 21, und einen Ausgangsanschluss 36 für die Halbbrücke, umfassend den High-Side-Halbleiterschalter 19 und den Low-Side-Halbleiterschalter 22. An die Ausgangsanschlüsse 34, 35 und 36 kann so jeweils eine Phase einer elektrischen Maschine, insbesondere eine Statorspule der elektrischen Maschine, angeschlossen werden.

Die Kontaktfinger der Stromschiene 27 und die Kontaktfinger des Ausgangsanschlusses, wie dem Ausgangsanschluss 34, 35 oder 36, sind jeweils ausgebildet, in einer flachen Erstreckung ineinanderzugreifen. Die Kontaktfinger der Stromschiene und des Ausgangsanschlusses sind so in einer gemeinsamen Ebene angeordnet und können gemeinsam zwischen dem High-Side-Halbleiterschalter 17 und dem Low-Side-Halbleiterschalter 20 - insbesondere nach Art eines Sandwiches - eingeschlossen sein.

Die Halbleiterschalter 17, 18, 19, 20 , 21 und 22 können in einer anderen Ausführungsform jeweils als IGBT ausgebildet sein. Der Source-Anschluss entspricht dann einem Emitteranschluss und der Drain-Anschluss entspricht einem Kollektoranschluss.

Die Halbleiterschalter weisen jeweils - einen in Figur 2 nicht dargestellten - Steueranschluss, insbesondere Gate-Anschluss auf und sind jeweils ausgebildet, an dem Gateanschluss ein Steuersignal zum Durchschalten des Halbleiterschalters zu empfangen und den Halbleiterschalter in Abhängigkeit des Steuersignals durchzuschalten oder zu sperren. Der Gate-Anschluss kann beispielsweise durch einen isolierten Bereich der Stromschiene 27 gebildet sein.

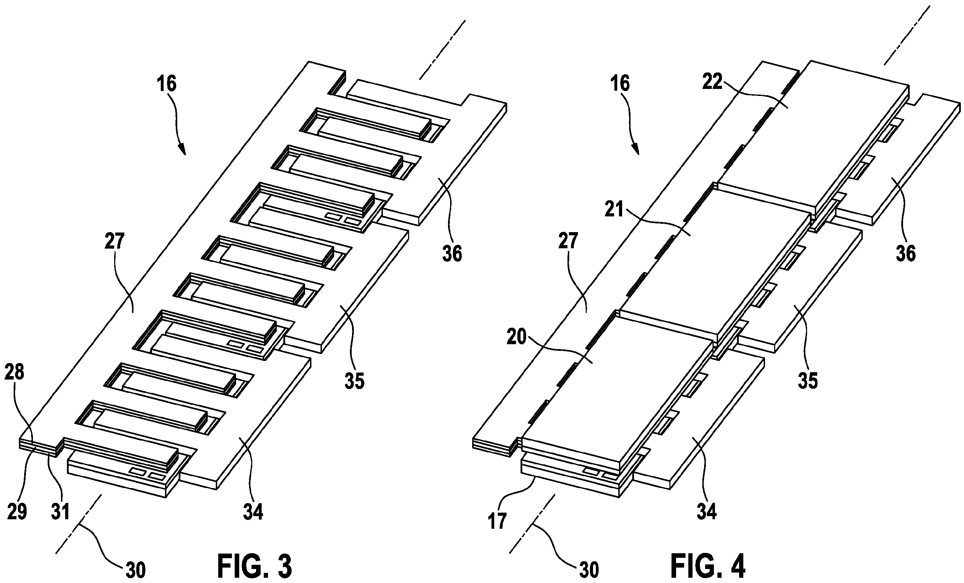

Figur 3 zeigt einen Fertigungsschritt zum Erzeugen eines Leistungsmoduls, umfassend die in Figur 2 bereits dargestellten Teile der in Figur 2 dargestellten Halbleiteranordnung 16. Die Kontaktfinger der Stromschiene 27 werden bei dem in Figur 3 dargestellten Fertigungsschritt mit der elektrisch leitfähigen Schicht 31 auf die Schaltstreckenanschlüsse der High-Side-Halbleiterschalter wie dem Halbleiterschalter 17, dem Halbleiterschalter 18 und dem Halbleiterschalter 19 aufgelegt, und - beispielsweise mittels einer Lotpaste und Reflow-Verlöten - elektrisch und stoffschlüssig verbunden. Die Kontaktfinger des Ausgangsanschlusses 34 werden auf die entsprechenden - wie in Figur 2 bereits beschriebenen - Schaltstreckenanschlüsse des High-Side-Halbleiterschalters 17 gelegt und mit einer Lotpaste - wie in Figur 1 beschrieben - mit den entsprechenden Schaltstreckenanschlüssen verlötet.

In dem selben Schritt wie in Figur 3 dargestellt können der Ausgangsanschluss 35 mit dem High-Side-Halbleiterschalter 18 und der Ausgangsanschluss 36 mit dem High-Side-Halbleiterschalter 19 verlötet werden.

Figur 4 zeigt einen Fertigungsschritt zum Erzeugen des Leistungsmoduls umfassend die in Figur 2 dargestellten Komponenten, bei dem die Low-Side-Halbleiterschalter 20, 21 und 22 auf die Stromschiene 27 und auf die Ausgangsanschlüsse 34, 35 und 36 aufgelegt und mit der Stromschiene 27 und den Ausgangsanschlüssen verlötet werden.

Der Ausgangsanschluss 34 verbindet so den Source-Anschluss des High-Side-Halbleiterschalters 17 mit dem Drain-Anschluss des Low-Side-Halbleiterschalters 20. Die Halbleiterschalter-Halbbrücken umfassend die gemäß Figur 4 zueinander parallel angeordneten Halbleiterschalter, nämlich den High-Side-Halbleiterschalter 17 und den Low-Side-Halbleiterschalter 20, welche gemeinsam eine Halbleiterschalter-Halbbrücke bilden, können so mittels der Stromschiene 27 an eine elektrische Spannungsquelle angeschlossen werden.

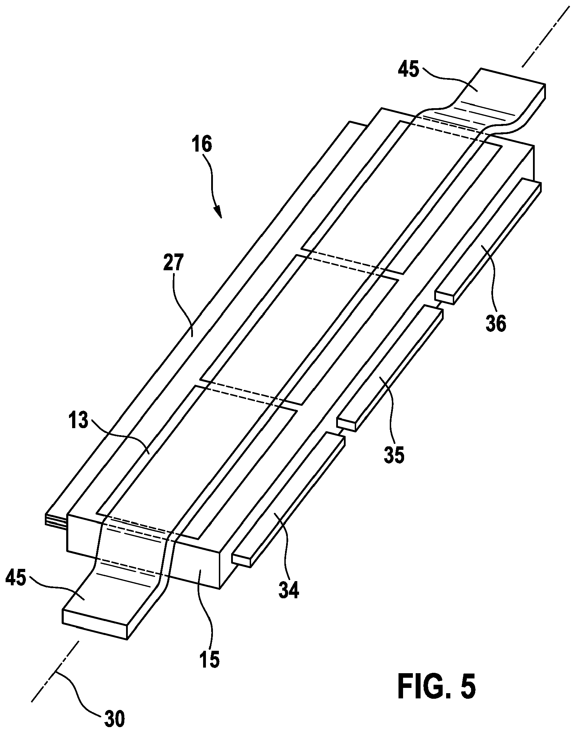

Figur 5 zeigt einen Fertigungsschritt zum Erzeugen des Leistungsmoduls, bei dem die in Figur 4 gezeigte Halbleiteranordnung mittels Moldmasse derart ummoldet wird, dass die Stromschiene 27 und die Ausgangsanschlüsse 34, 35 und 36 aus dem durch die insbesondere auspolymerisierte - Moldmasse gebildeten Moldkörper 15 herausragen.

Figur 5 zeigt auch eine Variante, bei der das Leistungsmodul mit einer Wärmesenke, in diesem Beispiel einem Kühlkörper 45 wärmeleitfähig verbunden ist. Die Isolierschicht 13 ist von dem Kühlkörper, insbesondere Kühlblech wärmeleitfähig kontaktiert, so dass Verlustwärme über den Kühlkörper 45 abgeführt werden kann. Der Kühlkörper 45 kann beispielsweise mit einer Heatpipe verbunden, oder selbst durch eine Heatpipe gebildet sein.

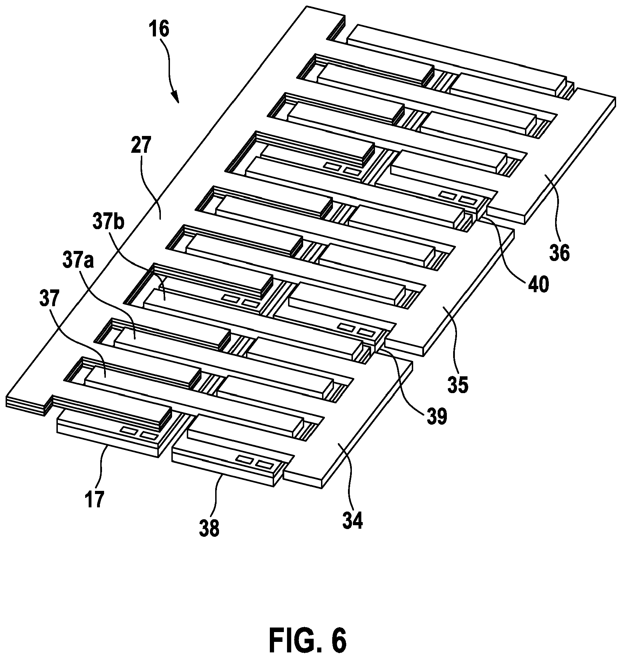

Figur 6 zeigt eine Variante der in den Figuren 2, 3 und 4 dargestellten Halbleiteranordnung, bei der die Halbleiterschalter-Halbbrücken jeweils ausgangsseitig mit einem Phasentrennschalter verbunden sind. Der Phasentrennschalter ist in diesem Ausführungsbeispiel durch einen Feldeffekttransistor, insbesondere entsprechend dem High-Side-Halbleiterschalter 17, ausgebildet.

Die High-Side-Halbleiterschalter wie der Halbleiterschalter 17, 18 und 19 sind jeweils mit ihrer flachen Erstreckung in derselben Ebene angeordnet, wie die Phasentrennschalter, nämlich einem Phasentrennschalter 38, welcher eingangsseitig mit dem Ausgang des High-Side-Halbleiterschalters 17 verbunden ist, einem Phasentrennschalter 39, welcher eingangsseitig mit der Halbbrücke umfassend den High-Side-Halbleiterschalter 18 verbunden ist und einen Phasentrennschalter 40, welcher eingangsseitig mit dem Ausgang der Halbbrücke umfassend den High-Side-Halbleiterschalter 19 und den Low-Side-Halbleiterschalter 22 verbunden ist.

Die Halbleiteranordnung 16 umfasst zum Verbinden des Phasentrennschalters 38 mit dem High-Side-Halbleiterschalter 17 ein elektrisch leitfähiges Verbindungselement 37, welches in diesem Ausführungsbeispiel als sich längserstreckende Kontaktfinger ausgebildet ist.

Das Verbindungselement 37 ist beispielsweise als insbesondere gestanztes oder lasergeschnittenes Blech, insbesondere Kupferblech, gebildet und greift mit einem Endabschnitt zwischen die Kontaktfinger 32 und 32a der Stromschiene 27 und kann so zwischen den Kontaktfingern 32 und 32a den Source-Anschluss 25 elektrisch kontaktieren. Das Verbindungselement 37 kontaktiert so anstelle des Kontaktfingers 33 - in der Halbleiteranordnung 16 in Figur 2 - den Source-Anschluss 25. Ein Endabschnitt des Verbindungselements 37 ist mit einem Schaltstreckenanschluss des Phasentrennschalters 38 lötverbunden, sodass der Source-Anschluss 25 des Halbleiterschalters 17, welcher gemeinsam mit dem Drain-Anschluss 24 des Low-Side-Halbleiterschalters 20 den bereits erwähnten Ausgang der Halbleiterschalterhalbbrücke bildet, mit dem Phasentrennschalter 38 verbunden ist.

Die Halbleiteranordnung 16 umfasst auch den Ausgangsanschluss 34, welcher in der Halbleiteranordnung 16 mit einem Schaltstreckenanschluss des Phasentrennschalters 38 verbunden ist.

Die Halbleiteranordnung 16 umfasst auch ein Verbindungselement 37a, welches sich mit einem Endabschnitt zwischen dem Kontaktfinger 32a und dem Kontaktfinger 32b erstreckt, und ein weiteres Verbindungselement 37b, welches sich zu dem Kontaktfinger 32b benachbart angeordnet erstreckt. Die Verbindungselemente 37, 37a und 37b bilden so einen Ausgang der Halbleiterschalter-Halbbrücke umfassend den High-Side-Halbleiterschalter 17 und den Low-Side-Halbleiterschalter 20 und verbinden diese Halbleiterschalter-Halbbrücke mit dem Phasentrennschalter 38. Die Stromschiene 27 und die Verbindungselemente wie das Verbindungselement 37 und die Ausgangsanschlüsse 34, 35 und 36 sind jeweils in einer gemeinsamen Ebene angeordnet.

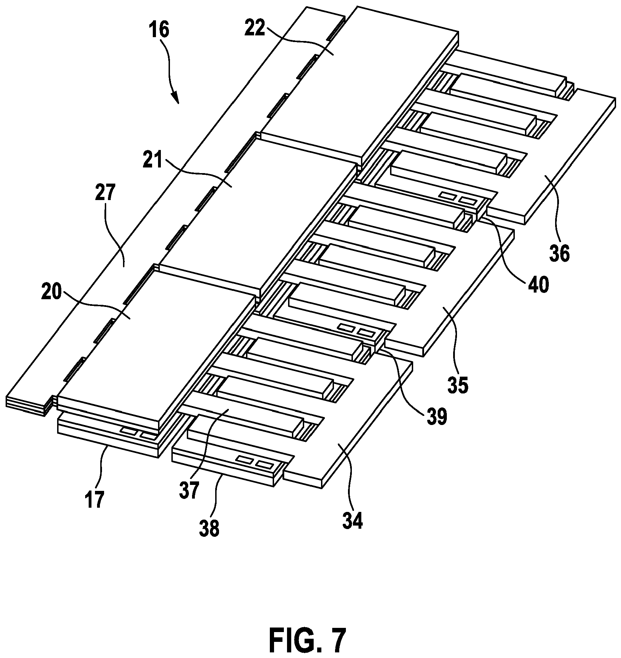

Figur 7 zeigt einen weiteren Fertigungsschritt zum Erzeugen des Leistungsmoduls, umfassend die Halbleiteranordnung 16, bei der in Figur 7 der Low-Side-Halbleiterschalter 20 zu dem High-Side-Halbleiterschalter 17 gegenüberliegend angeordnet ist, der Low-Side-Halbleiterschalter 21 zu dem High-Side-Halbleiterschalter 18 gegenüberliegend angeordnet ist und der Low-Side-Halbleiterschalter 22 zu dem High-Side-Halbleiterschalter 19 gegenüberliegend angeordnet ist. Die Low-Side-Halbleiterschalter 20, 21 und 22 werden jeweils über die Stromschiene 27, insbesondere die elektrisch leitfähige Schicht 28, mit Spannung versorgt, wobei die Drain-Anschlüsse als Ausgangsanschluss mit den Verbindungselementen wie dem Verbindungselement 37 elektrisch verbunden sind. Die Low-Side-Halbleiterschalter 20, 21 und 22 können jeweils mittels Reflow-Löten mit der Stromschiene 27 und mit dem Verbindungselement wie dem Verbindungselement 37 verlötet werden.

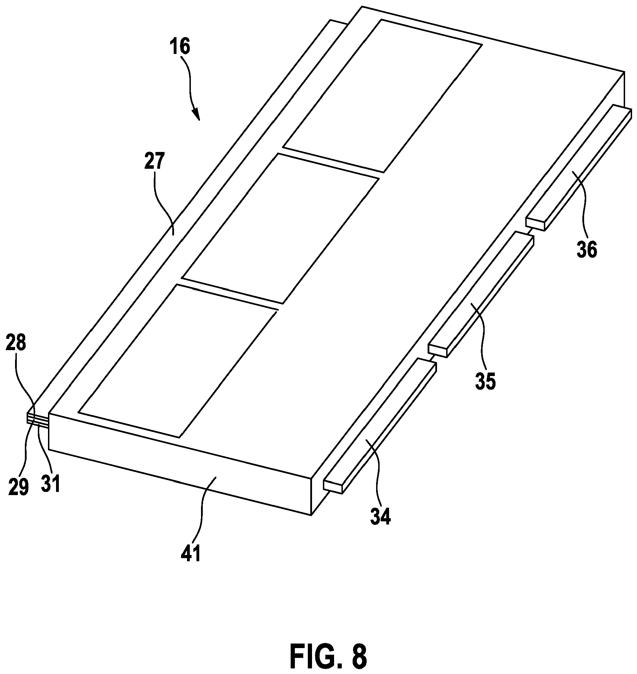

Figur 8 zeigt das Leistungsmodul, bei dem die in Figur 7 gezeigte Halbleiteranordnung 17 mittels einer Moldmasse derart eingebettet ist, dass die Stromschiene 27 und die Ausgangsanschlüsse 34, 35 und 36 aus einem durch die Moldmasse gebildeten Moldkörper 41 herausragen.

## Patentansprüche

1. Leistungsmodul (1, 16, 17) für einen Elektromotor, wobei das Leistungsmodul (1, 16, 17) wenigstens eine Halbleiterschalter-Halbbrücke (2, 3, 17, 18, 19, 20, 21, 22) umfasst,
**dadurch gekennzeichnet, dass**
die Halbleiterschalter-Halbrücke (2, 3, 17, 18, 19, 20, 21, 22) einen High-Side-Halbleiterschalter (2, 17, 18, 19) und einen Low-Side-Halbleiterschalter (3, 20, 21, 22) aufweist, wobei die Halbleiterschalter (2, 3, 17, 18, 19, 20, 21, 22) der Halbbrücke (2, 3) jeweils durch einen flach ausgebildeten Oberflächenbereich des Halbleiterschalters (2, 3, 17, 18, 19, 20, 21, 22) gebildete Schaltstreckenanschlüsse (4, 5, 6, 7, 23, 24, 25, 26) aufweisen, und die Schaltstreckenanschlüsse (4, 5, 6, 7, 23, 24, 25, 26) eines Halbleiterschalters jeweils in dieselbe Richtung weisen, wobei der High-Side-Halbleiterschalter (2) und der Low-Side-Halbleiterschalter (3) wenigstens eine elektrisch leitfähige Schicht (8, 9, 10, 28, 31, 34, 35, 36) zwischeneinander einschließen, welche einen Schaltstreckenanschluss (4, 6, 24, 26) des Low-Side-Halbleiterschalters (3, 20, 21, 22) und einen Schaltstreckenanschluss (5, 7, 23, 25) des High-Side-Halbleiterschalters (2) der Halbbrücke miteinander elektrisch verbindet, wobei durch wenigstens eine elektrisch leitfähige Schicht (8, 9, 10) ein Ausgangsanschluss der Halbbrücke gebildet ist.

2. Leistungsmodul (1, 16, 17) nach Anspruch 1,
**dadurch gekennzeichnet, dass**
die Schaltstreckenanschlüsse (4, 5, 6, 7, 23, 24, 25, 26) der Halbleiterschalter (2, 3, 17, 18, 19, 20, 21, 22) einer Halbbrücke einander gegenüberliegen.

3. Leistungsmodul (1, 16, 17) nach Anspruch 1 oder 2,
**dadurch gekennzeichnet, dass**
das Leistungsmodul (1, 16, 17) zur mehrphasigen Schaltung ausgebildet ist und für jede Phase wenigstens eine oder nur eine Halbleiterschalter-Halbbrücke aufweist.

4. Leistungsmodul (1, 16, 17) nach einem der vorhergehenden Ansprüche,
**dadurch gekennzeichnet, dass**
die elektrisch leitfähige Schicht (28, 31) eine Phasen-Stromschiene (27) aufweist, an die in einer flachen Erstreckung der Schicht wenigstens ein von der Phasen-Stromschiene (27) quer oder mit einer Querkomponente abweisende Kontaktfinger (33, 33a, 33b) angeformt ist, wobei der Kontaktfinger (33, 33a, 33b) die mit dem Ausgangsanschluss (34, 35, 36) verbundenen Schaltstreckenanschlüsse (24, 25) der Halbleiterschalterschalter (17, 20) miteinander verbindet.

5. Leistungsmodul (1, 16, 17) nach einem der vorhergehenden Ansprüche,
**dadurch gekennzeichnet, dass**
die Halbleiterschalter (2, 3, 17, 18, 19, 20, 21, 22) jeweils durch einen Feldeffekttransistor gebildet sind, wobei der mit dem Ausgangsanschluss der Halbbrücke verbundene Schaltstreckenanschluss des High-Side-Halbleiterschalters ein Source-Anschluss ist und der mit dem Ausgangsanschluss der Halbbrücke verbundene Schaltstreckenanschluss des Low-Side-Halbleiterschalters ein Drain-Anschluss ist.

6. Leistungsmodul (1, 16, 17) nach einem der vorhergehenden Ansprüche 1 bis 4,
**dadurch gekennzeichnet, dass**
die Halbleiterschalter (2, 3, 17, 18, 19, 20, 21, 22) jeweils durch einen Insulated-Gate-Bipolar-Transistor gebildet sind, wobei der mit dem Ausgangsanschluss der Halbbrücke verbundene Schaltstreckenanschluss des High-Side-Halbleiterschalters (2, 3, 17, 18, 19, 20, 21, 22) ein Emitter-Anschluss ist und der mit dem Ausgangsanschluss der Halbbrücke verbundene Schaltstreckenanschluss des Low-Side-Halbleiterschalters ein Kollektor-Anschluss ist.

7. Leistungsmodul (1, 16, 17) nach einem der vorhergehenden Ansprüche,
**dadurch gekennzeichnet, dass**
das Leistungsmodul eine Stromschiene (27) aufweist, an die wenigstens ein Kontaktfinger (32, 32a, 32b) angeformt ist, wobei der Kontaktfinger (32, 32a, 32b) einen Schaltstreckenanschluss zur Stromversorgung der Halbbrücke elektrisch kontaktiert.

8. Leistungsmodul (1, 16, 17) nach Anspruch 7,
**dadurch gekennzeichnet, dass**
der Kontaktfinger (32, 32a, 32b) zwei zueinander parallel angeordnete elektrisch leitfähige Schichten (28, 31) umfasst, welcher durch eine elektrisch isolierende Isolierschicht (29), insbesondere Dielektrikum, voneinander getrennt sind, wobei die Schichten (28, 29, 31) des Kontaktfingers (32, 32a, 32b) einander gegenüberliegende Anschlüsse (23, 26) zueinander verschiedener Halbleiterschalter (17, 20) kontaktieren.

9. Leistungsmodul (1, 16, 17) nach einem der Ansprüche 7 oder 8,
**dadurch gekennzeichnet, dass**
Kontaktfinger (32, 32a, 32b, 33, 33a, 33b) der Phasen-Stromschine (27) und der Stromschiene des Ausgangsanschlusses (34, 35, 36) jeweils ineinander greifen.

10. Leistungsmodul (1, 16, 17) nach einem der vorhergehenden Ansprüche,
**dadurch gekennzeichnet, dass**
das Leistungsmodul (1, 16, 17) in einen Moldkörper (15, 41) eingebettet ist.

## Claims

1. Power module (1, 16, 17) for an electric motor, wherein the power module (1, 16, 17) comprises at least one semiconductor switch half-bridge (2, 3, 17, 18, 19, 20, 21, 22),
**characterized in that**
the semiconductor switch half-bridge (2, 3, 17, 18, 19, 20, 21, 22) has a high-side semiconductor switch (2, 17, 18, 19) and a low-side semiconductor switch (3, 20, 21, 22), wherein the semiconductor switches (2, 3, 17, 18, 19, 20, 21, 22) of the half-bridge (2, 3) have in each case switching path terminals (4, 5, 6, 7, 23, 24, 25, 26) formed by a surface region of the semiconductor switch (2, 3, 17, 18, 19, 20, 21, 22), said surface region being embodied in a flat fashion, and the switching path terminals (4, 5, 6, 7, 23, 24, 25, 26) of a semiconductor switch in each case face in the same direction, wherein the high-side semiconductor switch (2) and the low-side semiconductor switch (3) enclose between one another at least one electrically conductive layer (8, 9, 10, 28, 31, 34, 35, 36) which connects a switching path terminal (4, 6, 24, 26) of the low-side semiconductor switch (3, 20, 21, 22) and a switching path terminal (5, 7, 23, 25) of the high-side semiconductor switch (2) of the half-bridge electrically to one another, wherein an output terminal of the half-bridge is formed by at least one electrically conductive layer (8, 9, 10).

2. Power module (1, 16, 17) according to Claim 1,
**characterized in that**
the switching path terminals (4, 5, 6, 7, 23, 24, 25, 26) of the semiconductor switches (2, 3, 17, 18, 19, 20, 21, 22) of a half-bridge are situated opposite one another.

3. Power module (1, 16, 17) according to Claim 1 or 2,
**characterized in that**
the power module (1, 16, 17) is designed for polyphase switching and has at least one or only one semiconductor switch half-bridge for each phase.

4. Power module (1, 16, 17) according to any of the preceding claims,
**characterized in that**
the electrically conductive layer (28, 31) has a phase busbar (27), onto which at least one contact finger (33, 33a, 33b) pointing away from the phase busbar (27) transversely or with a transverse component is integrally formed in a flat extension of the layer, wherein the contact finger (33, 33a, 33b) connects to one another the switching path terminals (24, 25) of the semiconductor switch switches (17, 20) that are connected to the output terminal (34, 35, 36).

5. Power module (1, 16, 17) according to any of the preceding claims,
**characterized in that**
the semiconductor switches (2, 3, 17, 18, 19, 20, 21, 22) are formed in each case by a field effect transistor, wherein that switching path terminal of the high-side semiconductor switch which is connected to the output terminal of the half-bridge is a source terminal and that switching path terminal of the low-side semiconductor switch which is connected to the output terminal of the half-bridge is a drain terminal.

6. Power module (1, 16, 17) according to any of the preceding Claims 1 to 4,
**characterized in that**
the semiconductor switches (2, 3, 17, 18, 19, 20, 21, 22) are formed in each case by an insulated gate bipolar transistor, wherein that switching path terminal of the high-side semiconductor switch (2, 3, 17, 18, 19, 20, 21, 22) which is connected to the output terminal of the half-bridge is an emitter terminal and that switching path terminal of the low-side semiconductor switch which is connected to the output terminal of the half-bridge is a collector terminal.

7. Power module (1, 16, 17) according to any of the preceding claims,
**characterized in that**
the power module has a busbar (27), onto which at least one contact finger (32, 32a, 32b) is integrally formed, wherein the contact finger (32, 32a, 32b) electrically contacts a switching path terminal for the power supply of the half-bridge.

8. Power module (1, 16, 17) according to Claim 7,
**characterized in that**
the contact finger (32, 32a, 32b) comprises two electrically conductive layers (28, 31) arranged parallel to one another and separated from one another by an electrically insulating insulation layer (29), in particular dielectric, wherein the layers (28, 29, 31) of the contact finger (32, 32a, 32b) contact terminals (23, 26) of mutually different semiconductor switches (17, 20), said terminals being situated opposite one another.

9. Power module (1, 16, 17) according to either of Claims 7 and 8,
**characterized in that**
contact fingers (32, 32a, 32b, 33, 33a, 33b) of the phase busbar (27) and of the busbar of the output terminal (34, 35, 36) in each case intermesh.

10. Power module (1, 16, 17) according to any of the preceding claims,
**characterized in that**
the power module (1, 16, 17) is embedded into a moulded body (15, 41).

## Revendications

1. Module de puissance (1, 16, 17) destiné à un moteur électrique, dans lequel le module de puissance (1, 16, 17) comprend au moins un demi-pont de commutateurs semi-conducteurs (2, 3, 17, 18, 19, 20, 21, 22),
**caractérisé en ce que** le demi-pont de commutateurs semi-conducteurs (2, 3, 17, 18, 19, 20, 21, 22) présente un commutateur semi-conducteur High-Side (2, 17, 18, 19) et un commutateur semi-conducteur Low-Side (3, 20, 21, 22), dans lequel les commutateurs semi-conducteurs (2, 3, 17, 18, 19, 20, 21, 22) du demi-pont (2, 3) présentent des raccords de section de commutation (4, 5, 6, 7, 23, 24, 25, 26) respectivement formés par une zone de surface de forme plate du commutateur semi-conducteur (2, 3, 17, 18, 19, 20, 21, 22), et les raccords de section de commutation (4, 5, 6, 7, 23, 24, 25, 26) d'un commutateur semi-conducteur sont orientés respectivement dans la même direction, dans lequel le commutateur semi-conducteur High-Side (2) et le commutateur semi-conducteur Low-Side (3) enferment entre eux au moins une couche électriquement conductrice (8, 9, 10, 28, 31, 34, 35, 36), qui relie électriquement un raccord de section de commutation (4, 6, 24, 26) du commutateur semi-conducteur Low-Side (3, 20, 21, 22) et un raccord de section de commutation (5, 7, 23, 25) du commutateur semi-conducteur High-Side (2) du demi-pont l'un à l'autre, dans lequel un raccord de sortie du demi-pont est formé par au moins une couche électriquement conductrice (8, 9, 10).

2. Module de puissance (1, 16, 17) selon la revendication 1,
**caractérisé en ce que** les raccords de section de commutation (4, 5, 6, 7, 23, 24, 25, 26) des commutateurs semi-conducteurs (2, 3, 17, 18, 19, 20, 21, 22) d'un demi-pont sont opposés l'un à l'autre.

3. Module de puissance (1, 16, 17) selon la revendication 1 ou 2,
**caractérisé en ce que** le module de puissance (1, 16, 17) est configuré pour un circuit à plusieurs phases et présente pour chaque phase au moins un ou seulement un demi-pont de commutateurs semi-conducteurs.

4. Module de puissance (1, 16, 17) selon l'une quelconque des revendications précédentes,
**caractérisé en ce que** la couche électriquement conductrice (28, 31) présente un rail de contact de phase (27), sur lequel un doigt de contact (33, 33a, 33b) s'écartant transversalement ou avec une composante transversale à partir du rail de contact de phase (27) est formé dans une extension plate de la couche, dans lequel le doigt de contact (33, 33a, 33b) relie l'un à l'autre les raccords de section de commutation (24, 25) des commutateurs des commutateurs semi-conducteurs (17, 20) reliés au raccord de sortie (34, 35, 36).

5. Module de puissance (1, 16, 17) selon l'une quelconque des revendications précédentes,
**caractérisé en ce que** les commutateurs semi-conducteurs (2, 3, 17, 18, 19, 20, 21, 22) sont respectivement formés par un transistor à effet de champ, dans lequel le raccord de section de commutation du commutateur semi-conducteur High-Side relié au raccord de sortie du demi-pont est un raccord source et le raccord de section de commutation du commutateur semi-conducteur Low-Side relié au raccord de sortie du demi-pont est un raccord de drain.

6. Module de puissance (1, 16, 17) selon l'une quelconque des revendications précédentes 1 à 4,
**caractérisé en ce que** les commutateurs semi-conducteurs (2, 3, 17, 18, 19, 20, 21, 22) sont respectivement formés par un Insulated Gâte Bipolar Transistor, dans lequel le raccord de section de commutation du commutateur semi-conducteur High-Side (2, 3, 17, 18, 19, 20, 21, 22) relié au raccord de sortie du demi-pont est un raccord d'émetteur et le raccord de section de commutation du commutateur semi-conducteur Low-Side relié au raccord de sortie du demi-pont est un raccord de collecteur.

7. Module de puissance (1, 16, 17) selon l'une quelconque des revendications précédentes,
**caractérisé en ce que** le module de puissance présente un rail de contact (27), sur lequel au moins un doigt de contact (32, 32a, 32b) est formé, dans lequel le doigt de contact (32, 32a, 32b) contacte électriquement un raccord de section de commutation pour l'alimentation électrique du demi-pont.

8. Module de puissance (1, 16, 17) selon la revendication 7,
caractérisé en ce le doigt de contact (32, 32a, 32b) comprend deux couches (28, 31) électriquement conductrices disposées parallèlement l'une à l'autre, qui sont séparées l'une de l'autre par une couche d'isolation (29) électriquement isolante, en particulier un diélectrique, les couches (28, 29, 31) du doigt de contact (32, 32a, 32b) venant en contact avec des raccords mutuellement opposés (23, 26) de commutateurs semi-conducteurs (17, 20) différents l'un de l'autre.

9. Module de puissance (1, 16, 17) selon une des revendications 7 ou 8,
**caractérisé en ce que** des doigts de contact (32, 32a, 32b, 33, 33a, 33b) du rail de contact de phase (27) et du rail de contact du raccord de sortie (34, 35, 36) s'engagent respectivement l'un dans l'autre.

10. Module de puissance (1, 16, 17) selon l'une quelconque des revendications précédentes,
**caractérisé en ce que** le module de puissance (1, 16, 17) est noyé dans un corps moulé (15, 41).
